# EUROPÄISCHE PATENTANMELDUNG

(11) **EP 0 673 087 A2**
(43) Veröffentlichungstag der Anmeldung: **20.09.1995**
(21) Anmeldenummer: 95103178.0
(22) Anmeldetag: 06.03.1995
(51) Int. Cl.: H01R 17/04, H01R 13/207

(54) **Anordnung zur elektrischen und mechanischen Verbindungen**

(30) Priorität: 14.03.1994 DE 9404277 U
(71) Anmelder: SIEMENS AKTIENGESELLSCHAFT, D-80333 München (DE)
(72) Erfinder: Bonath, Wolfgang, D-76275 Ettlingen (DE); Schmitt, Reinhard, D-76829 Landau (DE)

(57) **Zusammenfassung**

Die Erfindung betrifft eine Anordnung zur elektrischen und mechanischen Verbindung mit einem Anschlußelement (1) und einer Anschlußstelle (2), wobei Mittenkontakte (5, 7) und Außenkontakte (6, 8) der beiden Teile (1, 2) im wesentlichen koaxial zueinander angeordnet und jeweils axial voneinander beabstandet sind. Der Mittenkontakt (5) des Anschlußelements (1) ragt bei einer Verbindung durch eine Öffnung des Außenkontaktes (8) der Anschlußstelle (2) hindurch und ist mit dem Mittenkontakt (7) der Anschlußstelle (2) elektrisch verbindbar. Der Außenkontakt (6) des Anschlußelements (1) liegt zur elektrischen Verbindung am Rand der Öffnung des Außenkontakts (8) der Anschlußstelle (2) an. Befestigungsmittel (7, 9) halten die beiden Teile (1, 2) zusammen. Die Abmessungen und die Anordnung der Kontakte (5, 6) des Anschlußelements (1) sind im Verhältnis zu den Abmessungen und der Anordnung der Kontakte (7, 8) der Anschlußstelle (2) so bemessen, daß ein Kurzschluß der Anschlußstelle (2) unmöglich ist. Erfindungsgemäß wird die Anordnung zur Befestigung von Hochstromdioden in einer redundanten Gleichstromeinspeisung verwendet, wobei die Hochstromdioden in einem geeigneten Gehäuse untergebracht sind.

Die Erfindung wird angewandt in Automatisierungssystemen.

## Beschreibung

Die Erfindung betrifft eine Anordnung zur elektrischen und mechanischen Verbindung mit einem Anschlußelement und einer Anschlußstelle, ein Gehäuse für ein elektrisches Bauelement zur Verwendung als Anschlußelement sowie deren Verwendung.

In elektrischen Anlagen werden häufig zur Erfüllung besonders hoher Verfügbarkeitsanforderungen bestimmte Komponenten mit ungenügender Ausfallwahrscheinlichkeit redundant ausgeführt. D. h., diese Komponenten sind in der Anlage mehrfach vorhanden. So können beispielsweise mehrere Stromversorgungen vorgesehen sein, die über Dioden entkoppelt elektronische Geräte der Anlage mit der erforderlichen Gleichspannung versorgen. Auch durch den Ausfall einer der Stromversorgungen wird somit der Betrieb der Anlage nicht gefährdet. Problematisch ist dagegen der Austausch der Dioden während des Betriebs, da zwischen den Kontakten der Anschlußstelle eine Gleichspannung anliegt. Bei unsachgemäßer Handhabung besteht die Gefahr eines Kurzschlusses, so daß die Verfügbarkeit in diesem Fall nicht mehr gewährleistet ist.

Der Erfindung liegt die Aufgabe zugrunde, eine Anordnung zur elektrischen und mechanischen Verbindung eines Anschlußelementes mit einer Anschlußstelle zu schaffen, die auch unter Spannung sicher zu lösen und zu verbinden ist, sowie ein Gehäuse für ein elektrisches Bauelement, insbesondere für eine Diode, herzustellen, das eine Verwendung als Anschlußelement in der Anordnung erlaubt.

Zur Lösung dieser Aufgabe weist die neue Anordnung die im kennzeichnenden Teil des Anspruchs 1 und das neue Gehäuse für ein elektrisches Bauelement zur Verwendung als Anschlußelement die im kennzeichnenden Teil des Anspruchs 7 genannten Merkmale auf. In Anspruch 9 ist eine vorteilhafte Verwendung des neuen Gehäuses und der neuen Anordnung angegeben. In den Unteransprüchen 2 bis 6 und Anspruch 8 sind vorteilhafte Ausführungsformen der Erfindung beschrieben.

Anhand der Zeichnungen, in denen ein Ausführungsbeispiel der Erfindung dargestellt ist, werden im folgenden die Erfindung sowie Ausgestaltungen und Vorteile näher erläutert.

Es zeigen:
- Figur 1: ein Schnittbild durch eine erfindungsgemäße Anordnung,
- Figur 2: eine Explosionszeichnung eines erfindungsgemäßen Gehäuses mit Diode,
- Figur 3: ein montiertes Gehäuse nach Figur 2,
- Figur 4: eine Diodenbaugruppe zur redundanten Gleichstromeinspeisung,
- Figur 5: ein Prinzipschaltbild der Diodenbaugruppe und
- Figur 6: eine Diodenbaugruppe in einem Schrank.

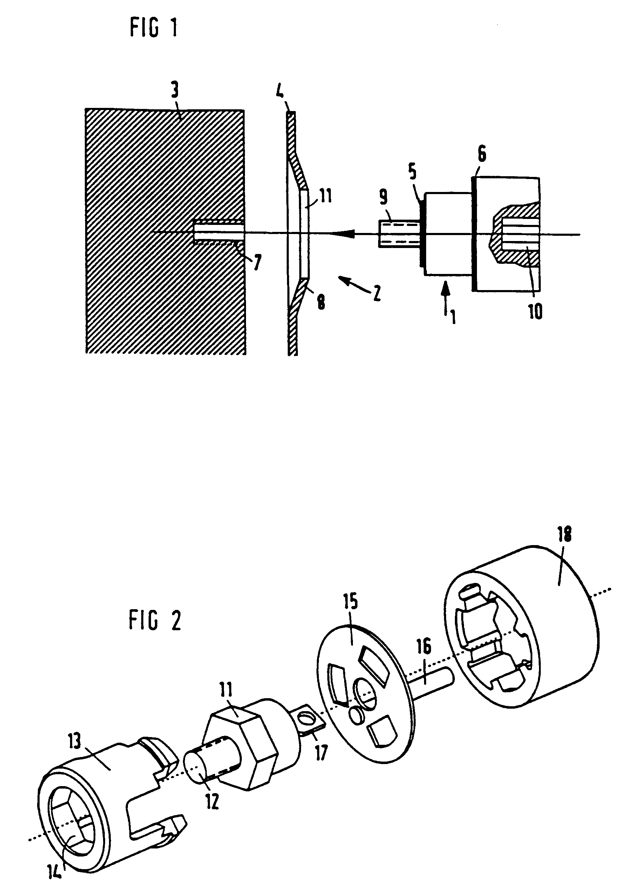

Die Anordnung in Figur 1 weist ein Anschlußelement 1 und eine Anschlußstelle 2 auf, die aus einem Kühlkörper 3 und einer Kontaktplatte 4 besteht. Das Anschlußelement 1 ist mit einem Mittenkontakt 5 und einem Außenkontakt 6 versehen, die Anschlußstelle mit einem Mittenkontakt 7 und einem Außenkontakt 8, die koaxial zueinander angeordnet sind. Der Mittenkontakt 5 des Anschlußelementes 1 ist ebenso wie der Mittenkontakt 7 der Anschlußstelle 2 gegenüber dem Außenkontakt 6 bzw. 8 axial versetzt. Der Mittenkontakt 5 weist einen ebenfalls koaxial angeordneten zylindrischen Schaft auf, der an seiner Zylinderfläche mit einem Außengewinde 9 versehen ist. In der Anschlußstelle 2 ist der Mittenkontakt 7 als dazu korrespondierendes Innengewinde realisiert. An dem Anschlußelement 1 ist ein Innensechskant 10 angebracht, um es beim Einsetzen oder Entfernen aus der Anschlußstelle 2 mit einem geeigneten Werkzeug drehen zu können. Der Einbau erfolgt also durch Einschrauben des zylinderförmigen Schaftes in den Mittenkontakt 7 der Anschlußstelle 2, wobei gleichzeitig mit der mechanischen Befestigung auch die elektrische Verbindung der Kontakte erreicht wird. Der Außenkontakt 8 der Anschlußstelle 2 ist federnd ausgeführt, so daß durch den Federweg ein Ausgleich der Bauteiletoleranzen bewirkt wird. Die Größe des Mittenkontaktes 5 des Anschlußelements 1 ist so bemessen, daß auf keinen Fall ein Kurzschluß zwischen den Kontakten 7 und 8 der Anschlußstelle möglich ist. Diese können auch durch den Außenkontakt 6 des Anschlußelements 1 nicht kurzgeschlossen werden, da der Abstand zwischen Mittenkontakt 7 und Außenkontakt 8 der Anschlußstelle 2 größer als der halbe Durchmesser einer kreisförmigen Öffnung 11 im Außenkontakt 8 ist, durch welche der Mittenkontakt 5 des Anschlußelements 1 in die Anschlußstelle 2 eingeführt wird. Obwohl in diesem Ausführungsbeispiel eine Schraubverbindung als mechanische Verbindung beschrieben ist, kann diese auch mit anderen Verbindungsarten realisiert werden, beispielsweise mit einer Federkraftklemme als Mittenkontakt 7 oder einer Schraubverbindung am äußeren Gehäuse des Anschlußelements 1 und im Umfangsbereich des Außenkontakts 8 der Anschlußstelle 2. Wenn als Anschlußelement 1 ein Leistungsbauelement eingesetzt wird und eine ausreichende Wärmeabfuhr zur Anschlußstelle 2 hin erforderlich ist, kann das Anschlußelement 1 über den Innensechskant 10 mit einem definierten Anzugsmoment im Kühlkörper 3 eingeschraubt werden, um diese zu gewährleisten.

In Figur 2 ist eine Explosionszeichnung eines Gehäuses mit einem axialen elektrischen Bauelement, das vorteilhaft als Anschlußelement geeignet ist, dargestellt. Das Gehäuse ist zur Aufnahme einer Hochstromdiode 49 mit Schraubkathodenanschluß 12 ausgebildet. Ein erstes Gehäuseteil 13 mit becherartiger Grundform ist mit einem Innensechskant 14 als Sitz für die Hochstromdiode 49 versehen. Der Schraubkathodenanschluß 12 ragt durch eine Öffnung im Becherboden hindurch und bildet so den Mittenkontakt des Anschlußelements. Ein Zweites Gehäuseteil 15 ist als Kontaktring ausgeführt und wird über ein Kupferseil 16 mit dem Lötanodenanschluß 17 der Hochstromdiode 49 verbunden. Der Durchmesser des Kontaktrings 15 ist größer als der Durchmesser des ersten Gehäuseteils 13, so daß er radial über die Umfangslinie des ersten Gehäuseteils 13 hinausragt. Durch den überstehenden Bereich des Kontaktrings 15 wird der Außenkontakt des Anschlußelements gebildet. Ein dritter Teil 18 aus nichtleitendem Material deckt den Kontaktring 15 ab. Das erste Gehäuseteil 13 ist mit drei Rasthebeln versehen, die durch Öffnungen im Kontaktring 15 gesteckt werden, im dritten Gehäuseteil 18 einen Rastvorsprung hintergreifen und auf diese Weise das Gehäuse durch eine Rastverbindung verriegeln. Die Hochstromdiode 49 ist damit im Gehäuse leicht austauschbar und verpolungssicher angeordnet.

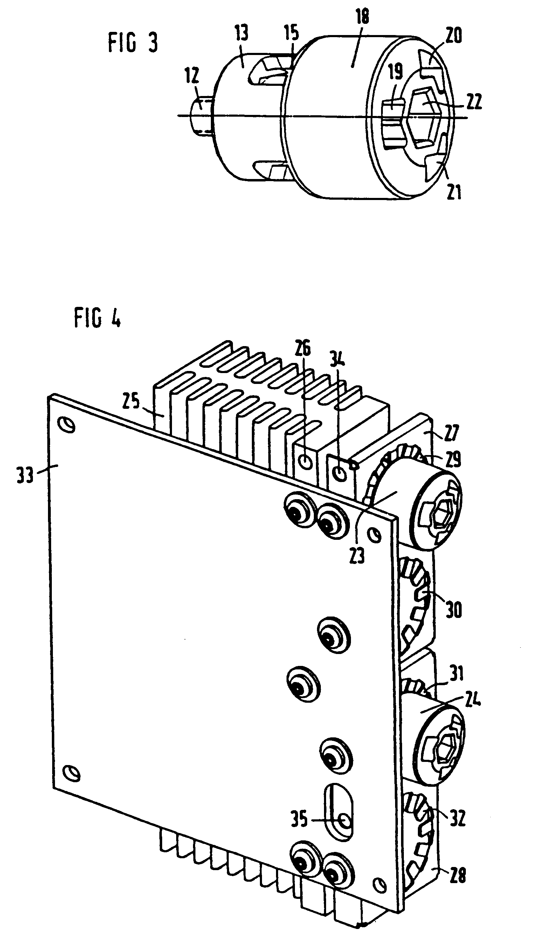

Figur 3 zeigt ein montiertes Gehäuse mit eingebauter Hochstromdiode. Darin sind gleiche Teile, die bereits in Figur 2 dargestellt wurden, auch mit gleichen Bezugszeichen versehen. Der Schraubkathodenanschluß 12 der Hochstromdiode ragt aus dem Boden des ersten Gehäuseteils 13 heraus. Zwischen dem ersten Gehäuseteil 13 und dem dritten Gehäuseteil 18 wird der Kontaktring 15 festgehalten. Durch drei Öffnungen 19, 20 und 21 in der Oberseite des dritten Gehäuseteils 18 kann mit einem geeigneten Werkzeug eingegriffen werden, um die Rastverbindung zwischen erstem Gehäuseteil 13 und drittem Gehäuseteil 18 zu lösen. Dioden können somit leicht aus dem Gehäuse entfernt und ausgetauscht werden. Das dritte Gehäuseteil ist an seiner Oberseite mit einem Innensechskant 22 versehen, damit das zum Eindrehen des Anschlußelements in die Anschlußstelle erforderliche Drehmoment einfach aufgebracht werden kann.

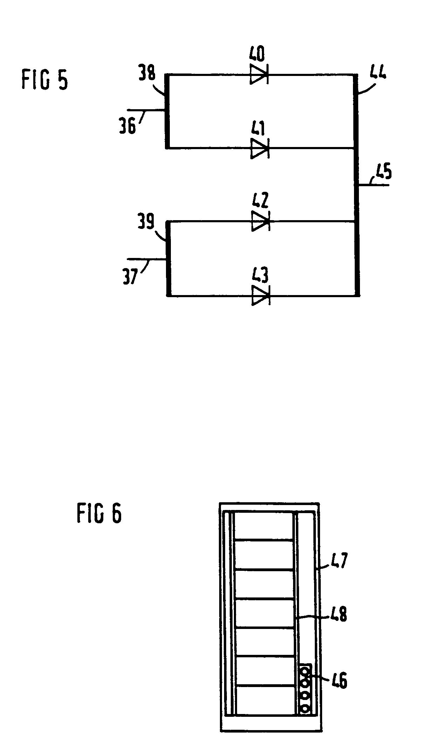

Eine Diodenbaugruppe nach Figur 4, die hier lediglich mit zwei Dioden in Gehäusen 23 und 24 bestückt ist, kann bei voller Bestückung elektrisch durch das Prinzipschaltbild nach Figur 5 beschrieben werden. Sie hat den Vorteil, daß keinerlei flexible Verdrahtung mit eventuell unterschiedlichen Leitungslängen notwendig ist. Die Aufteilung des Nennstroms auf zwei parallele Dioden weist daher bei voller Bestückung allenfalls eine geringe Unsymmetrie auf. Ein Kühlkörper 25 ist mit vier Gewindebohrungen versehen, von denen die obere Gewindebohrung 26 als Kathodenanschluß der Diodenbaugruppe dient. Vor dem Kühlkörper 25 sind zwei Kontaktplatten 27 und 28 mit jeweils zwei Kontaktzonen 29 und 30 bzw. 31 und 32, die als Außenkontakte von vier Anschlußstellen dienen, angeordnet. Im Kühlkörper 25 befinden sich vier zugehörige Innenkontakte in Form von Bohrungen mit Innengewinde, die in Figur 4 verdeckt sind. Die beiden Kontaktplatten 27 und 28 sind zusammen mit dem Kühlkörper 25 auf einer Isolierplatte 33 befestigt. Die Kontaktplatten 27 und 28 sind jeweils mit Bohrungen 34 bzw. 35 zum Anschluß des Anodenpotentials versehen. Da in diesem Ausführungsbeispiel jeweils eine Anschlußstelle mit einem Anschlußelement bestückt ist, kann über die Diodenbaugruppe redundant in ein elektrisches Gerät eingespeist werden. Bei einem Austausch der Anschlußelemente werden zunächst die beiden freien Anschlußstellen zusätzlich mit Anschlußelementen bestückt und erst dann die alten Anschlußelemente entfernt. Auf diese Weise wird die Redundanz der Einspeisung zu keinem Zeitpunkt unterbrochen. Das hat den Vorteil, daß die Funktion der Hochstromdioden in den alten Anschlußelementen nicht durch zeitraubende Messungen geprüft werden muß, bevor sie ausgebaut werden können.

Das Prinzipschaltbild in Figur 5 zeigt die elektrische Schaltung einer vollbestückten Diodenbaugruppe. Zwei in Figur 5 nicht dargestellte, redundant ausgeführte Stromversorgungen speisen über Zuleitungen 36 und 37 auf Kontaktplatten 38 und 39 ein, über welche die Anoden jeweils zweier Dioden 40, 41 bzw. 42, 43 miteinander verbunden sind. Die Kathoden der Dioden 40 ... 43 sind alle auf einen gemeinsamen Kühlkörper 44 geführt. Über eine Zuleitung 45 kann schließlich ein elektronisches Gerät redundant mit Gleichspannung versorgt werden.

Eine Diodenbaugruppe 46 kann gemäß Figur 6 in einem Schrank 47 seitlich von einem Gestell 48 angeordnet werden, das mit Baugruppenträgern als Verbraucher bestückt ist. Die Diodenbaugruppe 46 befindet sich vorteilhaft im Schrank 47 außerhalb der Entwärmungsströmung der installierten Verbraucher. Diese werden somit durch die Verlustleistung der Dioden nicht zusätzlich erwärmt. Die Zuleitung der Versorgungsspannung zu den einzelnen Verbrauchern im Schrank kann durch vertikal verlaufende Stromschienen erfolgen, so daß man weitgehend ohne flexible Leitungen auskommt. Der Kühlkörper der Diodenbaugruppe wird so dimensioniert, daß er bei Nennstrom die entstehende Verlustleistung der Dioden abführen kann. Für alle Dioden wird ein Kühlkörper vorteilhaft gemeinsam genutzt. Bei einem Wechsel werden nur die Dioden getauscht, der Kühlkörper verbleibt dagegen im Schrank 47. Beim Betrieb ist ein zyklischer Diodenaustausch notwendig, da ein Redundanzverlust durch Ausfall einer Diode wegen der Parallelschaltung nur schwer erkennbar ist. Andererseits ist eine aufwendige Überwachungsschaltung, welche den Ausfall einer Diode erkennen würde, aufgrund der hohen Lebensdauer von Dioden nicht notwendig. Die Erfindung hat weiterhin den Vorteil, daß bei geringem Einbauvolumen preisgünstige, handelsübliche Dioden verwendbar sind.

## Patentansprüche

1. Anordnung zur elektrischen und mechanischen Verbindung mit einem Anschlußelement (1) und einer Anschlußstelle (2), **dadurch gekennzeichnet**,
- daß Mittenkontakte (5, 7) und Außenkontakte (6, 8) des Anschlußelements (1) und der Anschlußstelle (2) im wesentlichen koaxial zueinander angeordnet und jeweils axial voneinander beabstandet sind,
- daß der Mittenkontakt (5) des Anschlußelements (1) durch eine Öffnung (11) des Außenkontakts (8) der Anschlußstelle (2) hindurchragt und mit dem Mittenkontakt (7) der Anschlußstelle (2) elektrisch verbindbar ist,
- daß der Außenkontakt (6) des Anschlußelements (1) zur elektrischen Verbindung am Rand der Öffnung (11) des Außenkontakts (8) der Anschlußstelle (2) anliegt,
- daß Befestigungsmittel (7, 9) vorhanden sind, welche das Anschlußelement (1) und die Anschlußstelle (2) zusammenhalten, und
- daß die Abmessungen und die Anordnung der Kontakte (5, 6) des Anschlußelements (1) im Verhältnis zu den Abmessungen und der Anordnung der Kontakte (7, 8) der Anschlußstelle (2) so bemessen sind, daß ein Kurzschluß der Kontakte (7, 8) der Anschlußstelle (2) durch die Kontakte (5, 6) des Anschlußelements (1) unmöglich ist.

2. Anordnung nach Anspruch 1**, dadurch gekennzeichnet**,
- daß die Länge des Mittenkontaktes (5) des Anschlußelements (1) kürzer als der Abstand der beiden Kontakte (7, 8) der Anschlußstelle (2) ist.

3. Anordnung nach Anspruch 1 oder 2, **dadurch gekennzeichnet**,
- daß der Außenkontakt (6) des Anschlußelements (1) als Kontaktring ausgeführt ist.

4. Anordnung nach einem der vorhergehenden Ansprüche, **dadurch gekennzeichnet**,
- daß als Befestigungsmittel (7, 9) eine Schraubverbindung vorgesehen ist.

5. Anordnung nach Anspruch 4, **dadurch gekennzeichnet**,
- daß der Mittenkontakt (5) des Anschlußelements (1) mit einem zylinderförmigen Schaft (9) mit Außengewinde versehen ist, der in ein korrespondierendes Innengewinde des Mittenkontaktes (7) der Anschlußstelle (2) schraubbar ist.

6. Anordnung nach Anspruch 5**, dadurch gekennzeichnet**,
- daß die Außenkontakte (6, 8) des Anschlußelements (1) und der Anschlußstelle (2) bei einer Verbindung axial federnd aneinanderliegen.

7. Gehäuse für ein elektrisches Bauelement, insbesondere für eine Diode (49) mit Schraubkathodenanschluß (12) und Lötanodenanschluß (17), zur Verwendung als Anschlußelement (1) in einer Anordnung nach einem der vorhergehenden Ansprüche, **dadurch gekennzeichnet**,
- daß das Gehäuse aus zumindest zwei Teilen besteht,
- daß das erste Gehäuseteil (13) aus isolierendem Material im wesentlichen becherartig zur Aufnahme eines Bauelementkörpers ausgebildet ist, wobei im Becherboden eine Öffnung zur Durchführung eines Mittenkontaktes vorhanden ist,
- daß das zweite Gehäuseteil (15) aus elektrisch leitendem Material im wesentlichen als verschließbarer Deckel für das erste Gehäuseteil (13) ausgebildet ist, der radial über die Umfangslinie des ersten Gehäuseteils (13) als Außenkontakt hinausragt.

8. Gehäuse nach Anspruch 7, **dadurch gekennzeichnet**,
- daß das zweite Gehäuseteil (15) als Kontaktring mit Öffnungen ausgeführt ist, durch welche Rasthebel einer Rastverbindung steckbar sind, und
- daß ein drittes Gehäuseteil (18) aus isolierendem Material das zweite Gehäuseteil (15) abdeckt und mit dem ersten Gehäuseteil (13) durch die Rastverbindung verriegelbar ist.

9. Verwendung eines Gehäuses nach Anspruch 7 oder 8 und einer Anordnung nach einem der Ansprüche 1 bis 6 für eine Hochstromdiode (49) mit Schraubkathodenanschluß (12) in einer redundanten Gleichstromeinspeisung eines elektronischen Geräts über mehrere Anschlußstellen, so daß durch Einschrauben die elektrische und mechanische Verbindung des Anschlußelements mit der Anschlußstelle erfolgt.
